Europäisches Patentamt

European Patent Office

Office européen des brevets

(11) Veröffentlichungsnummer: **0 503 448 A2**

# EUROPÄISCHE PATENTANMELDUNG

(21) Anmeldenummer: **92103652.1**

(22) Anmeldetag: **03.03.92**

(51) Int. Cl.5: **H01L 39/24**, H01L 39/14, H01L 39/20, H02H 9/02

(30) Priorität: **09.03.91 DE 4107686**

(43) Veröffentlichungstag der Anmeldung: **16.09.92 Patentblatt 92/38**

(84) Benannte Vertragsstaaten: **DE FR GB**

(71) Anmelder: **ABB PATENT GmbH Kallstadter Strasse 1 W-6800 Mannheim 1(DE)**

(72) Erfinder: **Abeln, Angelika, Dr. Breslauer Strasse 19 W-6940 Weinheim(DE)**
Erfinder: **Hermes, Stefan L 11, 6-7 W-6800 Mannheim(DE)**
Erfinder: **Knaak, Wolfgang, Dr. Langgewann 34 W-6900 Heidelberg(DE)**
Erfinder: **Jahnke, Bernd, Dr. Gottlob-Kamm-Strasse 11 W-6903 Neckargemünd(DE)**

(74) Vertreter: **Rupprecht, Klaus, Dipl.-Ing. et al c/o ABB Patent GmbH, Postfach 10 03 51 W-6800 Mannheim 1(DE)**

(54) **Verfahren zur Herstellung eines supraleitenden Strombegrenzers sowie ein entsprechend hergestellter Strombegrenzer.**

(57) Die Erfindung bezieht sich auf einen supraleitenden Strombegrenzer (1) mit wenigstens einem den Nennstrom tragenden Leiter (2), der wenigstens teilweise aus einem supraleitenden Material gefertigt wird. Erfindungsgemäß wird zur Ausbildung des Strombegrenzers (1) ein bandförmiger Leiter (2) verwendet, der durch eine metallische Schicht (3) begrenzt wird. Der Leiter (2) wird als bifilare Spule (7) aufgewickelt und in einer für strömende Medien durchlässigen Halterung (10) dauerhaft so angeordnet, daß seine Enden elektrisch leitend mit einem weiteren supraleitenden Strombegrenzer (1) in Serie oder parallel verschaltet werden können.

Fig. 1

Die Erfindung bezieht sich auf ein Verfahren zur Herstellung eines supraleitenden Strombegrenzers gemäß dem Oberbegriff des Patentanspruches 1, sowie auf einen nach diesem Verfahren hergestellten Strombegrenzer gemäß Anspruch 10.

Supraleitende Strombegrenzer sind bereits seit vielen Jahren bekannt. Sie sind in der Lage, Nennströme von vielen Ampere zu tragen, und können deshalb für Schaltzwecke in diesem Bereich verwendet werden. Entsprechendes ist der Informationsschrift "Theoretische und experimentelle Untersuchungen über die Eigenschaften eines großen supraleitenden Gleichstrombegrenzers mit 40 MW Schaltleistung bei einer Spannung von 47 kV" Kernforschungszentrum Karlsruhe KfK 2672 (1978) zu entnehmen.

Wegen seines verschwindenden elektrischen Widerstands verursacht das supraleitende Material des Strombegrenzers keinerlei ohmsche Verluste. Da dieser supraleitende Zustand nur unterhalb der kritischen Temperatur, dem kritischen Strom und dem kritischen Magnetfeld auftritt, kann das supraleitende Material eines Strombegrenzers aus dem supraleitenden Zustand durch Überhöhung eines dieser Parameter über den kritischen Wert hinaus in einen resitiven Zustand übergeführt werden. Solche Strombegrenzer sind in der Lage, Ströme auf einen Restwert zu begrenzen, der dann mit Hilfe eines Reststromschalters abgeschaltet werden kann. Wegen des relativ geringen elektrischen Widerstandes des supraleitenden Materials oberhalb der kritischen Temperatur $T_c$ ist für eine optiale Strombegrenzung ein sehr langer Leiter erforderlich, der induktivitätsarm in einem möglichst kleinen Volumen untergebracht werden muß.

Der Erfindung liegt die Aufgabe zugrunde, ein Verfahren zur Herstellung eines einfach verschaltbaren und leicht kühlbaren supraleitenden Strombegrenzers aufzuzeigen, sowie den Aufbau eiens solchen Strombegrenzers anzugeben.

Ein Verfahren zur Herstellung eines solchen supraleitenden Strombegrenzers wird durch die Merkmale des Patentanspruches 1 offenbart.

Ein supraleitender Strombegrenzer, der die geforderten Bedingungen der Aufgabe erfüllt, ist in Patentanspruch 10 offenbart.

Zur Bildung des Leiters wird keramisches oder metallisches supraleitendes Material verwendet, das von einer metallischen Schicht umgeben wird. Der Leiter kann durch eine Hülse gebildet werden, die mit supraleitendem Material ausgefüllt wird. Ferner können zur Bildung des Leiters auch Fasern mit einer supraleitenden Beschichtung bzw. Fasern, die vollständig aus einem supraleitenden Material hergestellt sind, benutzt werden. Ebenso ist es möglich, Substrate mit einer supraleitenden Beschichtung zu versehen, und dieses als Leiter zu verwenden. Die Fasern bzw. Substrate werden zur bessseren Kontaktierung mit weiteren Bauteilen mit einer metallischen Schicht umgeben, die ebenso wie die Hülse vorzugsweise aus Silber gefertigt wird. Der Leiter, dessen Enden vor Korrosion und Abätzung geschützt sind, wird zu einer bifilaren Spule gewickelt und auf einer porösen oder mit einer Vielzahl von Löchern versehenen Grundplatte gehaltert. Anschließend wird der Leiter zusammen mit der Grundplatte in ein poröses Material aus Keramik oder Glas eingebettet. Dieses wird zur Ausbildung einer festen Halterung mit porösen Eigenschaften einer Temperaturbehandlung unterzogen. Hierdurch wird der Leiter auf der Grundplatte dauerhaft fixiert. Seine Enden sind so gehaltert, daß sie aus dem porösen Körper nach außen überstehen und problemlos mit einem weiteren Leiter eines Strombegrenzers verschaltet werden können. Aufgrund der Porosität der Halterung ist es möglich, den Leiter isostatisch zu pressen, so daß er hierdurch die notwendige Stromdichte erhält. Da der Leiter über eine poröse Halterung mit der Grundplatte verbunden ist, und diese ebenfalls porös ausgebildet oder mit Löchern versehen ist, kann ein flüssiges oder gasförmiges Kühlmittel problemlos durch die Halterung geführt und damit der Leiter umströmt werden.

Weitere erfindungswesentliche Merkmale sind in den Unteransprüchen gekennzeichnet.

Die Erfindung wird nachfolgend anhand von schematischen Zeichnungen näher erläutert. Es zeigen:

Fig. 1    einen Ausschnitt aus einem supraleitenden Strombegrenzer,

Fig. 2    einen für die Fertigung verwendeten Leiter,

Fig. 3    einen fertiggestellten supraleitenden Strombegrenzer.

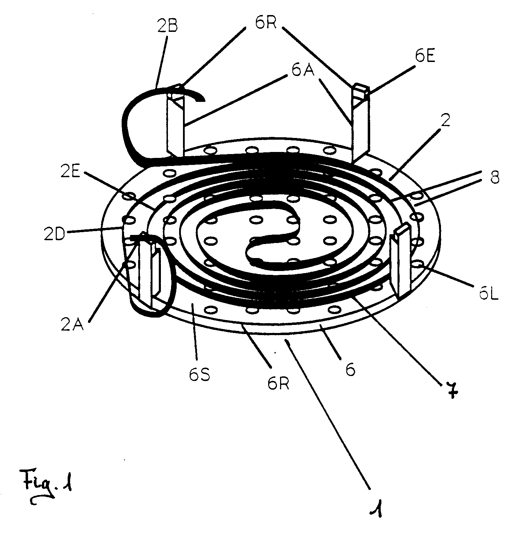

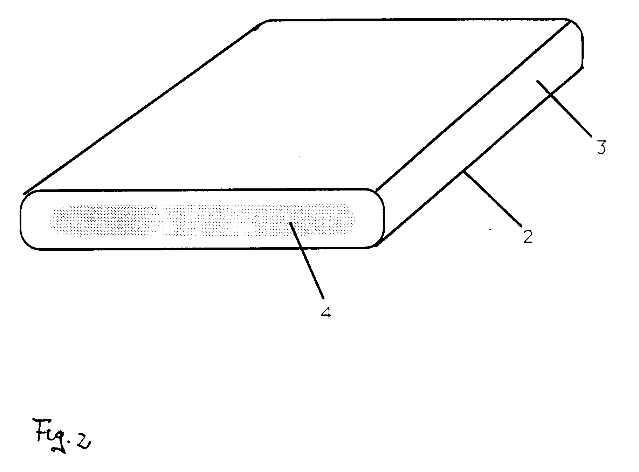

Der in Fig. 1 dargestellte Teilbereich eines Strombegrenzers 1 umfaßt den Leiter 2 des Strombegrenzers sowie eine Grundplatte 6. Der Leiter 2 wird, wie Fig. 2 zeigt, nach außen hin durch eine Hülse 3 aus Metall begrenzt. Bei dem hier dargestellten Ausführungsbeispiel ist die Hülse 3 aus Silber gefertigt. Sie kann auch aus einem anderen Material, das ähnliche Eigenschaften wie Silber aufweist, gefertigt werden. Der Innenbereich der Hülse 3 ist mit pulverförmigem keramischen Material 4 ausgefüllt, das später seine supraleitenden Eigenschaften erhält. Vorzugsweise wird hierfür Yttrium-Barium-Kupferoxid ($Y_1Ba_2Cu_3O_x$) oder Wismutkuprat (BiSrCaCu0) verwendet, wobei x einen Wert von etwa 7 aufweist. Die Hülse 3 wird nach dem Füllen mit dem supraleitenden Material 4 auf einen kleineren Durchmesser gezogen, gewalzt und gesintert, wobei einige dieser Schritte mehrmals durchgeführt werden können, so daß der Leiter 2 die Form eines Bandes aufweist. Der Leiter kann auch aus Fasern oder Substraten hergestellt werden, die mit einem supraleitenden Material beschichtet sind. Die Fertigung des Leiters aus Fasern, die vollständig aus einem supraleitenden Material hergestellt sind, ist ebenfalls möglich. In allen Fällen wird der Leiter von einer metallischen Schicht umgeben, die ebenso wie die Hülse der Kontaktierung dient. Vorzugsweise wird die Schicht auch aus Silber gefertigt. Als supraleitendes Material können an Stelle der oben angegebenen Werkstoffe auch NbTi, $Nb_3Sn$ oder Chevrel-Phasen verwendet werden.

Die Enden des Leiters 2 sind durch einen Überzug, z.B.-aus Platin, gegen Korrosion und Abätzung geschützt. Der bandförmige Leiter 2 wird zu einer bifilaren Spule 7 aufgewickelt. Anschließend wird diese Spule auf die Grundplatte 6 aufgelegt und dort befestigt. Dies kann durch Löten, keramisches Kleben oder Klemmen erfolgen. Es besteht auch die Möglichkeit, die Oberfläche der Grundplatte mit einer Nut zu versehen, in welche der Leiter gelegt und über eine Wärmebehandlung fixiert werden kann.

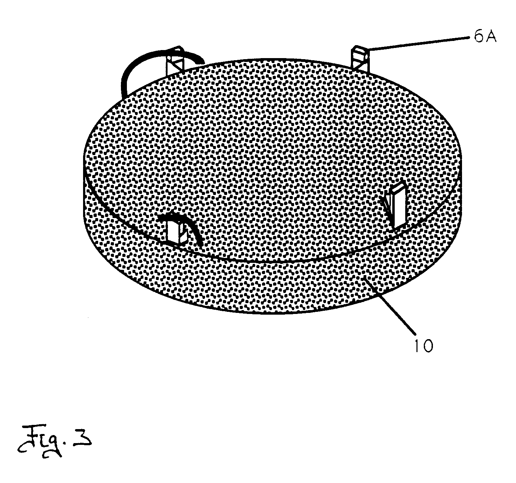

Wie anhand von Fig. 1 zu sehen ist, besteht zwischen zwei aufeinanderfolgenden Leiterabschnitten 2D und 2E ein definierter Abstand 8. Dieser wird dadurch erreicht, daß beim Aufwickeln der Spule 7 zwischen zwei aufeinanderfolgenden Leiterabschnitten 2D und 2E jeweils ein Abstandhalter in Form eines Bandes (hier nicht dargestellt) angeordnet wird. Nach dem Auflegen der Spule 7 auf die Grundplatte 6 werden die Abstandhalter (hier nicht dargestellt) entfernt. Die Grundplatte 6 ist aus einem nicht leitenden Material gefertigt. Hierfür eignet sich beispielsweise eine Glaskeramik oder stabilisiertes Zirkoniumdioxid. Die Grundplatte 6 ist entweder porös oder mit Löchern 6L ausgebildet. Jede Grundplatte 6 ist wenigstens auf ihrer ersten Oberfläche 6S mit Abstandhaltern 6A versehen, die in dem Randbereich 6R der Grundplatte 6 in definiertem Abstand voneinander so angeordnet sind, daß ihre Längsachsen senkrecht zur Grundplatte 6 verlaufen. Die Abstandhalter 6A sind an ihren freien Enden mit Ausnehmungen 6E versehen, die es gestatten, eine weitere Grundplatte (hier nicht dargestellt), aufzusetzen und zu haltern. Die Enden 2A und 2B der Spule 7 sind an jeweils einem dieser Abstandhalter 6A gehaltert. Die in Fig. 1 dargestellte Anordnung wird innerhalb eines Behälters (hier nicht dargestellt) angeordnet und vollständig in ein Keramik- oder Glasgranulat (hier nicht dargestellt) eingebettet. Die Korngröße des verwendeten Keramik- oder Glasgranulats liegt zwischen 30 $\mu$m und 2 mm. Die Einbettung erfolgt derart, daß die beiden Enden 2A und 2B des Leiters 2 aus dem Granulat herausragen. Anschließend wird die eingebettete Anordnung einer Temperaturbehandlung von z.B. 800 bis 900 °C unterzogen. Dies geschieht in einer Atmosphäre, die den für den Temperaturprozeß des Leiters 2 notwendigen Sauerstoffanteil aufweist. Eine Atmosphäre mit 7% Sauerstoff und 93% Stickstoff ist hierfür geeignet. Dabei sintert das Keramik- oder Grasgranulat zu einem festen und porösen, eine Halterung bildenden Körper 10 zusammen. Gleichzeitig werden die supraleitenden Eigenschaften des Leiters 2 ausgebildet. Der während des Sinterns gebildete Keramik- oder Glaskörper 10 ist so ausgebildet, daß strömende Medien in Form von Gas oder Flüssigkeit durch ihn hindurchgeleitet werden können. Insbesondere ist seine Porosität so groß, daß eine optimale Kühlung des Leiters 2 gewährleistet wird. Ferner ist es möglich eine ausreichende Menge einer ätzenden Lösung hindurchzuleiten, mit der die Hülse 3 abgeätzt werden kann, so daß der Leiter 2 nur noch aus dem supraleitenden Material besteht. Nach der Fertigstellung des Keramikkörpers 10 wird dieser kalt isostatisch gepreßt. Durch die Porosität des Keramikkörpers ist diese Behandlung des eingebetteten supraleitenden Materials möglich. Das Pressen ist erforderlich, um dem Leiter 2 die notwendige Stromdichte zu verleihen, die er für die Funktion als Strombegrenzer 1 benötigt. Falls die Hülse 3 aus Silber gefertigt ist, kann diese dadurch entfernt werden, daß ein Komplexbildner durch den Keramik- oder Glaskörper 10 hindurchgeleitet wird, bzw. der gesamte Körper in einem entsprechenden Bad angeordnet wird. Hierdurch wird erreicht, daß die aus Silber gefertigte Hülse 3 vollständig entfernt wird. Nach der Beseitigung der Hülse 3 wird der Keramik- oder Glaskörper 10 mit einer reinigenden Flüssigkeit durchgespült. Die Trocknung des Keramik-oder Glaskörpers 10 erfolgt vorzugsweise mit Azeton. Die Entfernung der metallischen Hülse 3 führt nicht nur zur Vergrößerung des strombegrenzenden Widerstands des Leiters 2. Vielmehr wird gleichzeitig das supraleitende Material von dem umgebenden Keramikmaterial abgelöst. Dadurch wird erreicht, daß unterschiedliche Temperaturen zwischen dem Leiter 2 und der Umgebung, die bei Schaltvorgängen auftreten können, nicht zu mechanischen Spannungen zwischen den verschiedenen Bauelementen des Strombegrenzers 1 führen. Wie anhand von Fig. 3 zu sehen ist, ragen die Enden des Leiters 2 über den gesinterten Keramik- oder Glaskörper 10 hinaus. Auf den Abstandhaltern 6A kann ein weiterer Keramik- oder Glaskörper 10 mit eingebettetem Leiter 2 angeordnet werden. Dessen Leiterenden können dann seriell oder parallel mit dem Leiter 10 des in Fig. 3 dargestellten Strombegrenzers 1 verschaltet werden.

**Patentansprüche**

1. Verfahren zur Herstellung eines supraleitenden Strombegrenzers (1) mit wenigstens einem der Nennstrom tragenden Leiter (2), dadurch gekennzeichnet, daß wenigstens ein teilweise aus supraleitendem Material gefertigter Leiter (2) in einer für strömende Medien durchlässigen Halterung dauerhaft so positioniert wird, daß seine beiden Enden mit weiteren Strombegrenzern verbunden werden können.

2. Verfahren nach Anspruch 1, dadurch gekennzeichnet, daß zur Bildung des Leiters (2) metallische oder keramische supraleitende Materialien verwendet werden, die von einer metallischen Schicht (3) umgeben werden.

3. Verfahren nach Anspruch 1 oder 2, dadurch gekennzeichnet, daß zur Bildung des Leiters (2) Yttrium-Barium-Kupferoxid $(Y_1 Ba_2 Cu_3 O_x)$, Wismutkuprat (BiSrCaCuO), NbTi, $Nb_3Sn$ oder Chevrel-Phasen verwendet wird, das von einer metallischen Schicht (3) umgeben wird.

4. Verfahren nach einem der Ansprüche 1 bis 3, dadurch gekennzeichnet, daß der Leiter (2) duch eine mit supraleitendem Material gefüllte Hülse (3), aus Fasern mit einer supraleitenden Beschichtung, aus Fasern, die vollständig aus supraleitendem Mateial bestehen oder aus einem Substrat mit supraleitender Beschichtung gebildet wird, und daß die Fasern und Substrate von einer metallischen Schicht (3) umgeben werden, die ebenso wie die Hülse (3) aus einem metallischen Material gefertigt wird.

5. Verfahren nach einem der Ansprüche 1 bis 4, dadurch gekennzeichnet, daß die metallische Hülse oder Schicht (3) des Leiters (2) aus Silber gefertigt wird, und daß die Enden des Leiters (2) durch eine Beschichtung aus Platin vor Korrosion und Atzung geschützt werden.

6. Verfahren nach einem der Ansprüche 1 bis 5, dadurch gekennzeichnet, daß der Leiter (2) als bifilare Spule (7) gewickelt und zwischen zwei aufeinanderfolgenden Leiterabschnitten (2D und 2E) jeweils ein bandförmiger Abstandhalter angeordnet wird, daß die bifilare Spule (7) auf einer porösen oder mit einer Vielzahl von Löchern (6L) versehenen Grundplatte (6) gehaltert wird, und daß die zwischen den Leiterabschnitten (2D und 2E) angeordneten Abstandhalter nach der Befestigung der Spule (7) auf der Grundplatte (6) entfernt werden.

7. Verfahren nach einem der Ansprüche 1 bis 6, dadurch gekennzeichnet, daß der Leiter(2) zusammen mit der Grundplatte (6) so in eine poröse Masse aus Keramik- oder Glasgranulat mit einer Korngröße zwischen 30 $\mu$m und 2

mm eingebettet und anschließend zur Ausbildung einer Halterung (10) bei einer Temperatur von 800 bis 900°C in einer sauerstoffhaltigen Atmosphäre zur Ausbildung der Porosität der Halterung (10) geglüht wird, daß die freien Enden des Leiters (2) aus der Halterung (10) herausragen.

8. Verfahren nach einem der Ansprüche 1 bis 7, dadurch gekennzeichnet, daß der in die Halterung (10) eingebettete Leiter(2) einem isostatischen Preßverfahren unterzogen wird, und daß die den Leiter (2) umgebende metallische Hülse oder Schicht(3) durch Ätzen entfernt wird.

9. Verfahren nach einem der Ansprüche 1 bis 8, dadurch gekennzeichnet, daß jede Grundplatte (6) wenigstens einseitig in ihrem Randbereich (6R) mit Abstandhaltern (6A) versehen wird, die in definiertem Abstand voneinander angeordnet und so gehalten werden, daß wenigstens eine weitere Halterung (10) eines Strombegrenzers (1) darauf abgestützt und befestigt werden kann.

10. Supraleitender Strombegrenzer (1) mit wenigstens einem den Nennstrom tragenden Leiter (2), dadurch gekennzeichnet, daß der Leiter (2) aus einem supraleitenden Material besteht, auf einer Grundplatte (6) gehaltert und zusammen mit dieser in einen für strömende Medien durchlässgen porösen Keramik- oder Glasgranulatkörper (10) dauerhaft eingebett ist, und daß die Enden des Leiters (2) aus dem porösen Keramik- oder Glasgranulatkörper (10) zur Verbindung mit einem weiteren Leiter (2) eines Strombegrenzers (1) herausgeführt sind.

Fig. 1

Fig. 2

6A

10

Fig. 3